Europäisches Patentamt

European Patent Office

Office européen des brevets

(11) Publication number: **0 108 910**
**B1**

## EUROPEAN PATENT SPECIFICATION

(45) Date of publication of patent specification: **19.04.89**

(51) Int. Cl.⁴: **H 01 L 23/28, H 01 L 21/314**

(21) Application number: **83109942.9**

(22) Date of filing: **05.10.83**

(54) Method of forming a passivated compound semiconductor substrate.

(30) Priority: **10.11.82 US 440654**

(43) Date of publication of application:
**23.05.84 Bulletin 84/21**

(45) Publication of the grant of the patent:
**19.04.89 Bulletin 89/16**

(84) Designated Contracting States:
**DE FR GB**

(56) References cited:
**US-A-3 959 098**

**JOURNAL OF VACUUM SCIENCE AND TECHNOLOGY, vol. 19, no. 2, July/August 1981, pages 255-256, American Vacuum Society, New York, US; S.P. KOWALCZYK et al.: "Protection of molecular beam epitaxy grown AlxGa1-xAs epilayers during ambient transfer"**

**PATENTS ABSTRACTS OF JAPAN, vol. 5, no. 137 (E-72) 809r, 29th August 1981; & JP-A-56-71 942**

(73) Proprietor: **International Business Machines Corporation**
**Old Orchard Road**
**Armonk, N.Y. 10504 (US)**

(72) Inventor: **Freeouf, John Lawrence**
**Route 3 Box 121**
**Peekskill New York 10566 (US)**
Inventor: **Jackson, Thomas Nelson**
**2 Feeney Road**
**Ossining New York 10562 (US)**
Inventor: **Oelhafen, Peter University of Basel**
**Institute of Physics Klingelberg Strasse 82**
**CH-4056 Basel (CH)**
Inventor: **Pettit, George David**
**Austin Road**
**Mathopac New York 10541 (US)**
Inventor: **Woodall, Jerry MacPherson**
**336 Cherry Street**
**Bedford Hills New York 10507 (US)**

(74) Representative: **Hobbs, Francis John**
**IBM United Kingdom Limited Intellectual Property Department Hursley Park**
**Winchester Hampshire SO21 2JN (GB)**

(56) References cited:

APPLIED PHYSICS LETTERS, vol. 39, no. 1, July 1981, pages 76-78, American Institute of Physics, New York, US; F.W. OSTERMAYER et al.: "Photoelectrochemical etching of p-GaAs"

INTERNATIONAL JOURNAL OF ELECTRONICS, vol. 52, no. 1, January 1982, pages 89-93, Taylor & Francis Ltd., Basingstoke, Hampshire, GB; H. ADACHI et al.: "Experimental data on light emission behaviour from GaAs Schottky contacts"

EXTENDED ABSTRACTS, vol. 82-1, May 1982, pages 402-403, no. 248, Pennington, New Jersey, US; L.-M. WANG et al.: "Etching characteristics and kinetics of a new etching solution system for GaAs, HC1-H2O2-H2O"

THIN SOLID FILMS, vol. 46, no. 1, October 1977, pages 17-45, Elsevier Sequoia S.A., NL; C.W. WILMSEN et al.: "MOS processing for III-V compound semiconductors: overview and bibliography"

# EP 0 108 910 B1

**Description**

This invention is concerned with the passivation of compound semiconductor substrates.

Crystalline compound semiconductor materials have a number of advantages but such materials require special care in fabrication operations. One major limitation is that oxides which form on the surface of the compound semiconductor crystals which receive further processing, require removal prior to some types of subsequent processing operations. Since the material involves more than one element, more than one oxide can form, with some oxides being harder to remove than others. Thus, processing difficulties are encountered which may require special steps or high temperatures which frequently are incompatible with other processing operations.

Prior procedures for generating clean and atomically ordered surfaces of compound semiconductors that have already been air exposed, for example, Gallium Arsenide (GaAs) and Gallium Aluminum Arsenide (GaAlAs), include thermal annealing, normal and high temperature ion bombardment and annealing (IBA).

In addition, as reported in J. Vac. Sci. Tech. *19* (2), Aug. 1981, pages 255 and 256, already clean surfaces of GaAs, GaAlAs epitaxial layers that have been formed in ultrahigh vacuum (UHV) conditions by the molecular beam epitaxy (MBE) method have been protected by coating with As prior to removal from the UHV conditions into air.

For air exposed surfaces, the prior art procedures provide clean surfaces for further processing but they require a removal step which generally involves temperatures which are so high as to introduce other problems such as the diffusion of impurities from precise locations or out of the substrate or prevent patterning for device circuitry.

The invention seeks to provide a method of forming an air exposable semiconductor substrate having a passivation layer which is easily removed using non-detrimental steps and low temperatures to provide an oxide free, clean and well ordered surface, capable of localized processing.

The invention provides a method of forming a passivated compound semiconductor body, comprising immersing a monocrystalline single compound semiconductor substrate in a bath of 1:1 $HCl:H_2O$ while illuminating the substrate for a period of 10 to 30 minutes with a light having a photon energy greater than the energy gap width of said compound semiconductor at a power density of greater than 0.01 watts/cm$^2$, in order to form a layer of the most volatile element of the compound semiconductor on a surface of the substrate.

The invention will now be described by way of example, with reference to the accompanying drawings; in which:—

Fig. 1 represents a semiconductor substrate passivated by a method in accordance with the invention; and

Fig. 2 represents a prior art passivated semiconductor substrate.

In order to facilitate explanation, the description is directed to the passivation of a particular semiconductor compound; however, it will be apparent to one skilled in the art in the light of the principles set forth that the teaching may be readily applied to other semiconductor compound materials such as Indium Arsenide (InAs), Gallium Indium Arsenide (GaInAs) and Gallium Aluminum Arsenide (GaAlAs).

For the material Gallium Arsenide (GaAs), the necessary thickness of the most volatile element As layer will be governed by the harshness of the environmental conditions until the further processing takes place. Under normal temperature and corrosiveness conditions, such as room temperature in air, an arsenic layer of 1 to 50 nm, (10 to 500Å) is satisfactory. Where the semiconductor intermediate product is GaAs, it may be formed by the exposure of at least the future processing surface of a crystalline GaAs member to light with a photon energy of greater than 1.8 eV at a power density of 0.01 to 0.5 W/cm$^2$, while the GaAs is immersed in a 1:1 $HCl:H_2O$ mixture or other solutions which do not etch the more volatile element for a period of 10 to 30 minutes.

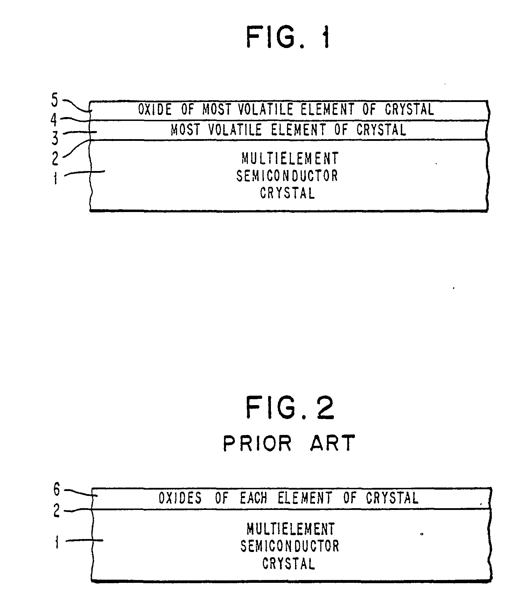

The resulting structure is schematically illustrated in Fig. 1 wherein the upper surface is illustrative of the surface on which future processing·is to occur.

The structure as illustrated in Fig. 1 is contrasted with the prior art as shown in Fig. 2 in that the layer 6 involves oxides of each element of the multielement semiconductor.

Referring to Fig. 1, a GaAs crystalline member 1, such as a wafer, is provided on the future processing surface 2˘with a layer of arsenic 3. In Fig. 1, an oxide layer 5 is shown on the upper surface 4 of the layer 3. When the wafer is handled in air, a layer 5 of arsenic oxide forms. The layer 5 may be formed by exposing the layer 3 to an oxidizing environment.

The structure of Fig. 1 is a passivated body which permits a wafer of GaAs to be stored on the shelf in relaxed environmental constraints and at the time of use the layers 5 and 3 can be readily and predictably removed at relatively low temperatures by merely baking at temperatures of the order of 150 to 500°C.

The problem solved by the invention has been a limitation to the fabrication of devices in the art especially where the devices are formed in an epitaxial layer grown on the surface of a substrate wafer. In order to form epitaxial layers of GaAs, GaAlAs, etc., on GaAs substrate wafers, and in order for the layers to have good optical and electrical qualities and to have epitaxial layer substrate interfaces which have low defect densities, the GaAs substrate surface must be free of any native oxides yet must be fully crystalline in structure at the surface with minimum defects. However, annealing GaAs at the temperatures necessary

3

to remove the oxides and especially the non-volatile element oxides will result in an accumulation of defects and unwanted impurities at the surfaces. Therefore, there are limits to the ability to remove oxides.

Where the method of liquid phase epitaxial growth is employed, the substrate wafer is generally baked in hydrogen at temperatures greater than 650°C, then the GaAs substrate wafer surface is placed in contact with an undersaturated liquid phase melt which first dissolved some of the surface and then with a temperature drop there is epitaxial growth.

In the case of the technique of chemical vapor deposition, CVD, the GaAs substrate is generally etched in HCL acid vapor, at greater than 600°C prior to the CVD growth.

In the case of the molecular beam epitaxy (MBE) technique it is normally required to anneal the substrate at temperatures above 550°C to remove the oxide and to produce an atomically ordered surface prior to epitaxial growth.

In each technique, temperatures in excess of 550°C and as high as 640°C are required to ensure than the surface of the GaAs substrate will be free of any oxide inclusions and will be adequate for high yield semiconductor devices. This requirement is quite rigorous because in a broad array a single one micron region of oxide in a large series circuit can render the entire circuit inoperative.

The arsenic layer 3 is the higher volatility element and the oxide thereof is layer 5 both of which come off easily at low temperature. Further, the arsenic prevents the formation of all other less volatile oxides such as gallium oxide which does not come off easily or entirely until the temperature is raised to undesirable levels such as 550°C, which is detrimental to the product being produced.

By photoetching the GaAs 1 surface 2 under controlled conditions, a continuous film of arsenic 3 is formed on the GaAs which does not dissolve easily. The arsenic layer 3 at surface 4 then in turn partially oxidizes in air or can be oxidized to form an arsenic oxide layer 5.

By way of example, a monocrystalline substrate wafer of n-type GaAs having a [100] crystallographic orientation is prepared using standard chemical cleaning procedures such as an etch in 7:1:1 $H_2SO_4$:$H_2O_2$:$H_2O$ and thereafter a rinse in deionized water.

The n-type GaAs wafer is then placed in a 1:1 HCl water solution for a period of about 10 to 30 minutes. During that time, the wafer is irradiated with a 0.01 to 0.5 watt/cm$^2$ light having a photon energy in excess of 1.8 eV. The 1.8 eV level is higher than the bandgap of GaAs.

During that time the photoetch products including the gallium species are dissolved in the solution leaving a GaAs wafer 1 with a layer of arsenic 3 1 to 20 nm (10 to 200Å) thick over the surface 2 and upon exposure to air, a further layer of arsenic oxide will form on the surface 4 of the arsenic 3.

The substrate wafer may then be handled and stored in air.

When it is subsequently desired to conduct further epitaxial growth or other processing, the wafer is annealed at 150°C to 500°C. In the annealing, at 150°C most of the surface layer 3 of arsenic will desorb, and all will be gone at 300°C. Temperatures above 300°C up to the 500°C level may be used for metallization operations such as alloying.

The wafer is generally n-conductivity type doped with Si, although one skilled in the art may make substitutions for different conductivity types.

An arsenic layer may be generated on a semi-insulating GaAs surface by photoetching while maintaining the GaAs in an anodic bias condition. On the other hand, p-type samples require a bias to produce a hole current while photoetching. Under certain conditions, an anodic bias alone will be sufficient to produce the layer of the most volatile element As.

The properties of the characteristics of the layer 3 have been determined through the use of standard surface science tools and the data for a number of samples is shown in Table 1.

TABLE 1

| SURFACE | TREATMENT | ESCA Ga/As | ESCA O/GaAs | LEED PATTERN |
|---------|-----------|------------|-------------|--------------|
| (100) | Air Exposed | 0.63 | 0.63 | none |
| (100) | Photo Etched (PE) | 0.36 | 0.24 | none |
|  | 350°C | 0.72 | 0.13 | yes |
| (100) | PE | 0.39 | 0.17 | none |
|  | 350°C | 0.73 | 0.11 | yes |
| (100) | PE | 0.27 | 0.37 | — |
|  | 300°C | 0.63 | 0.18 | yes |
| (100) | PE | 0.28 | 0.03 | — |
| (100) | PE | 0.07 | 0.13 | — |
| (100) | PE | 0.06 | 0.12 | — |
|  | 150eV/145°C | 0.18 | 0.03 | yes |
|  | 290°C | 0.63 | 0.04 | — |
| (100) | PE | 0.51 | 0.33 | — |
|  | 200eV/160°C | 0.71 | 0.02 · | yes |

The data in Table 1 is provided involving the standard in the art test techniques of "Electron Spectroscopy for Chemical Analysis" (ESCA) and "Low Energy Electron Diffraction" (LEED).

The data in Table 1 illustrates that for an air exposed [100] surface the GaAs surface is stoichiometric with respect to gallium and arsenic (Ga/As = 0.63), and that the surface contains a relatively large amount of oxide (O/GaAs = 0.63) and is disordered (no LEED pattern). The photoetched surface has a relatively large As concentration (Ga/As = 0.06 to 0.51), has a relatively low oxide concentration (O/GaAs = 0.03 to .33) and is disordered (no LEED pattern).

A 300°C anneal of a photoetched surface results in a stoichiometric surface (Ga/As = 0.63 to 0.73) and an ordered surface (LEED pattern). It should be noted that an air exposed surface of the prior art would require a 600°C anneal to achieve the same properties as a 300°C anneal of a photo-etched surface.

## Claims

1. A method of forming a passivated compound semiconductor body, comprising immersing a monocrystalline single compound semiconductor substrate in a bath of 1:1 $HCl:H_2O$ while illuminating the substrate for a period of 10 to 30 minutes with a light having a photon energy greater than the energy gap width of said compound semiconductor at a power density of greater than 0.01 watts/cm$^2$, in order to form a layer (3) of the most volatile element of the compound semiconductor on a surface of the substrate.

2. A method as claimed in claim 1, in which the compound semiconductor is GaAs, InAs, GaInAs or GaAlAs.

3. A method as claimed in claim 2, in which the compound semiconductor is GaAs and said layer (3) consists of As and is formed on a surface of the substrate having a [100] crystallographic orientation.

4. A method as claimed in claim 3, in which the layer of As is 1 to 50 nm (10Å to 500Å) thick.

5. A method as claimed in claim 3 or claim 4, in which said power density is in the range of 0.01 to 0.5 watts/cm$^2$.

6. A method as claimed in claim 3 or claim 4, in which the GaAs is doped with silicon.

## Patentansprüche

1. Verfahren zur Herstellung eines passivierten zusammengesetzten Halbleitersubstrats, wobei ein monokristallines Einzelverbindungs-Halbleitersubstrat in ein Bad von 1:1 $HCl:H_2O$ eingetaucht wird,

während das Substrat für eine Dauer zwischen 10 und 30 Minuten mit einem Licht bestrahlt wird, welches eine Photonenenergie aufweist, die größer ist als die Energiebreite der Bandlücke des Verbindungshalbleiters bei einer Leistungsdichte oberhalb von 0,01 Watt/cm², um auf der Oberfläche des Substrats eine Schicht (3) des flüchtigsten Elements des Verbindungshalbleiters zu bilden.

2. Verfahren nach Anspruch 1, bei welchem der Verbindungshalbleiter GaAs, InAs, GaInAs oder GaAlAs ist.

3. Verfahren nach Anspruch 2, bei welchem der Verbindungshalbleiter GaAs ist und die Schicht (3) aus As besteht und auf einer Oberfläche des Substrats mit einer [100] Kristallorientierung gebildet wird.

4. Verfahren nach Anspruch 3, bei welchem die Arsenschicht 1 bis 50 nm (10Å bis 500Å) dick ist.

5. Verfahren nach Anspruch 3 oder 4, bei welchem die Leistungsdichte im Bereich von 0,01 bis 0,5 Watt/cm² ist.

6. Verfahren nach Anspruch 3 oder 4, bei welchem das GaAs mit Silizium dotiert ist.

**Revendications**

1. Procédé de formation d'un corps semiconducteur composite passivé, comprenant une immersion d'un substrat semiconducteur composite unique monocristallin dans un bain HCL/H₂O de proportions 1/1 en même temps qu'une irradiation du substrat pendant une durée de 10 à 30 minutes par une lumière ayant une énergie de photon supérieure à la largeur de bande interdite du semiconducteur composite et une densité de puissance supérieure à 0,01 watts/cm³, pour former une couche (3) de l'élément le plus volatil du semiconducteur composite sur une surface du substrat.

2. Procédé selon la revendication 1, dans lequel le semiconducteur composite est du GaAs, InAs, GaInAs ou GaAlAs.

3. Procédé selon la revendication 2, dans lequel le semiconducteur composite est GaAs et dans lequel ladite couche (3) est constituée d'As et est formée sur une surface du substrat ayant une orientation cristallographique [100].

4. Procédé selon la revendication 3, dans lequel la couche d'As a une épaisseur de 1 à 50 nm (10 à 500 angströms).

5. Procédé selon la revendication 3 ou 4, dans lequel la densité de puissance est comprise entre 0,01 et 0,5 watts/cm².

6. Procédé selon la revendication 3 ou 4, dans lequel le GaAs est dopé avec du silicium.

# FIG. 1

| | |
|---|---|
| 5 | OXIDE OF MOST VOLATILE ELEMENT OF CRYSTAL |
| 4 | MOST VOLATILE ELEMENT OF CRYSTAL |
| 3 | |
| 2 | MULTIELEMENT |
| 1 | SEMICONDUCTOR CRYSTAL |

# FIG. 2

## PRIOR ART

| | |
|---|---|
| 6 | OXIDES OF EACH ELEMENT OF CRYSTAL |
| 2 | MULTIELEMENT |
| 1 | SEMICONDUCTOR CRYSTAL |